Europäisches Patentamt

European Patent Office

Office européen des brevets

(19)

(11) Numéro de publication : **0 472 460 B1**

(12)

# FASCICULE DE BREVET EUROPEEN

(45) Date de publication du fascicule du brevet :
**14.12.94 Bulletin 94/50**

(51) Int. Cl.⁵ : **H04B 7/26,** H04B 1/66,
H03M 7/18

(21) Numéro de dépôt : **91402262.9**

(22) Date de dépôt : **19.08.91**

(54) **Procédé et installation de radio téléphonie numérique, notamment de radio-téléphonie cellulaire de communication avec les mobiles.**

(30) Priorité : **20.08.90 FR 9010485**

(43) Date de publication de la demande :
**26.02.92 Bulletin 92/09**

(45) Mention de la délivrance du brevet :
**14.12.94 Bulletin 94/50**

(84) Etats contractants désignés :
**BE DE DK ES GB IT LU NL SE**

(56) Documents cités :
**US-A- 850 036**

(56) Documents cités :
**IEEE JOURNAL ON SELECTED AREAS IN
COMMUNICATION, Vol. SAC-5, No. 5, Juin
1987, New York US, pages 835-848, J.L. Dornstetter et Al.: "Cellular Efficiency with Slow
Frequency Hopping: Analysis of the Digital
SHF900 Mobile System"
INTERNATIONAL JOURNAL OF ELECTRO-
NICS, Vol. 61, No. 1, Juillet 1986, London GB,
pages 79-84, S.N. Saloum et Al.:
"Binary-to-Residue and Residue-to-Binary
Conversters"**

(73) Titulaire : **MATRA COMMUNICATION
50, rue du Président Sadate
F-29101 Quimper (FR)**

(72) Inventeur : **Mouly, Michel
49, rue Louise Bruneau
F-91120 Palaiseau (FR)**

(74) Mandataire : **Fort, Jacques
CABINET PLASSERAUD
84, rue d'Amsterdam
F-75009 Paris (FR)**

EP 0 472 460 B1

## Description

PROCEDE ET INSTALLATION DE RADIO-TELEPHONIE NUMERIQUE, NOTAMMENT DE RADIO-TELEPHONIE CELLULAIRE DE COMMUNICATION AVEC LES MOBILES

La présente invention concerne de façon générale les procédés et installations de radio-téléphonie numérique dont la mise en oeuvre exige qu'une infrastructure fixe diffuse, périodiquement et à fréquence élevée, vers des postes émetteurs-récepteurs, des numéros d'ordre de fréquences constituant un sous-ensemble quelconque, de cardinal au plus égal à une valeur déterminée n, d'un ensemble de fréquences prédéterminées de cardinal N.

L'invention trouve une application particulièrement importante en radio-téléphonie (le terme radio-téléphonie devant être interprété dans un sens large et comme concernant aussi bien la transmission de données que celle de la parole) qualifiée de cellulaire, dont les normes sont en cours d'élaboration par la conférence européenne des administrations des postes et télécommunications. On pourra trouver une description des caractéristiques générales de ces installations dans l'article "Le système cellulaire numérique européen de communication avec les mobiles", par B. GHILLEBAERT et autres, dans l'Echo des Recherches, n° 131, premier trimestre 1988. Les aspects de la radio-téléphonie cellulaire numérique sur lesquels porte particulièrement la présente invention sont notamment décrits dans la recommandation GSM 04.08 "Mobile radio interface layer 3 specification", publiée en mars 1990 par le groupe spécial "Systèmes mobiles publics de radio-télécommunication" de la CEPT.

Dans une installation de radio-téléphonie cellulaire telle que définie ci-dessus, l'infrastructure doit transmettre, sur des canaux de diffusion, deux listes de fréquences répétées à intervalle régulier. Une première liste est celle des fréquences sur lesquelles, dans une cellule ou une zone donnée, le poste mobile doit fonctionner en modulation à saut de fréquence (cf. US-A-4 850 036). Une seconde liste est celle des fréquences des canaux de diffusion que le poste doit surveiller en mode d'attente, en vue d'effectuer une sélection de cellule, et en mode connecté, pour des besoins de mesure et de comparaison.

A titre indicatif, il est à l'heure actuelle prévu de communiquer, à une cadence de l'ordre de la seconde, la liste des fréquences à surveiller. Il est également prévu de communiquer à un poste mobile émetteur-récepteur, sur requête d'allocations de celui-ci, les numéros d'ordre des fréquences qui lui sont attribués pour la transmission, ces fréquences constituant un sous-ensemble, de cardinal au plus égal à n = 16, d'un ensemble de $N = 2^{10} = 1\ 024$ fréquences.

Le mode de transmission doit permettre d'adopter n'importe lequel des sous-ensembles possibles, ce qui exclut le procédé qui consiste, dans le cas d'un nombre de sous-ensembles limité, à affecter à chacun un numéro d'identification qui serait seul transmis. La transmission individuelle du numéro d'ordre de chaque fréquence du sous-ensemble retenu exigerait, dans le cas le plus défavorable, de coder 16 numéros d'ordre, chacun sur 10 bits.

La présente invention vise, de façon générale, à réduire le volume d'informations binaires nécessaire pour transmettre les numéros d'ordre de fréquences à utiliser, ces numéros d'ordre pouvant être considérés comme des éléments appartenant à un ensemble O,...,N-1. Elle vise plus particulièrement à donner une solution simple à ce problème lorsque le nombre d'éléments N est égal ou peu supérieur à une puissance entière de 2, c'est-à-dire lorsque N est égal ou peu supérieur à $2^k$ (k étant un entier).

Dans ce but, l'invention propose notamment un procédé de radio-téléphonie numérique, suivant lequel : on diffuse, à partir d'une infrastructure fixe vers des postes mobiles émetteurs-récepteurs, les numéros d'ordre de fréquences de travail, constituant un sous-ensemble quelconque, de cardinal au plus égal à une valeur déterminée n, d'un ensemble de fréquences prédéterminées de cardinal N ; on identifie, dans chaque poste à l'écoute, des fréquences du sous-ensemble à partir des numéros d'ordre et on provoque le fonctionnement du poste sur les fréquences identifiées,

caractérisé en ce que, pour diffuser les numéros d'ordre de fréquences appartenant à un ensemble de cardinal $2^k - 1$, on détermine le numéro V de la fréquence pour laquelle la moitié des fréquences restantes a un numéro d'ordre inférieur et la moitié des fréquences restantes a un numéro d'ordre supérieur à V ; on identifie le numéro de la fréquence retenue sur k bits ; on renumérote les numéros d'ordre des deux groupes de fréquences divisés ; on répète la détermination du numéro de la fréquence sur chaque groupe et on définit les deux fréquences de partition sur k-1 bits ; on répète les opérations de renumérotation, de détermination et de définition jusqu'à épuisement des numéros d'ordre à transmettre ; on transmet l'ensemble des numéros d'ordre des fréquences de partition suivant une séquence déterminée, connue de l'émetteur-récepteur ; et on détermine les fréquences de travail à partir des numéros d'ordre dans le poste.

Les termes "numéro d'ordre inférieur" et "numéro d'ordre supérieur" ne doivent pas être interprétés comme impliquant une relation d'ordre, mais comme indiquant que les numéros d'ordre appartiennent à la moitié de

EP 0 472 460 B1

l'ensemble d'origine précédant la valeur et suivant la valeur, respectivement, dans une disposition circulaire. Ainsi, le numéro V de la fréquence de partition appartenant au sous-ensemble peut être considéré comme délimitant, dans l'intervalle [0, $2^k$ - 2], deux groupes contenant les $2^{k-1}$ - 1 numéros respectivement précédant et suivant V dans une disposition circulaire dudit intervalle, V étant choisi tel que L(n/2) numéros de fréquences du sous-ensemble appartiennent à l'un des deux groupes, L(.) désignant la partie entière.

Le procédé est applicable pour toutes les valeurs de N. Toutefois, il présente un intérêt particulier dans le cas où N est de la forme $2^k$ - 1 car, cela évite d'utiliser une arithmétique à radical mélangé et donc simplifie les calculs en substituant de simples décalages à des opérations de multiplication ou de division.

Ce cas particulier se rencontre très souvent.

Souvent en effet le nombre de fréquences possibles, c'est-à-dire le nombre N des éléments de l'ensemble, est de la forme $2^k$, pour des motifs liés à l'utilisation d'une transmission en mode binaire. On peut alors aisément réduire le nombre des éléments de $2^k$ à $2^k$ - 1 en identifiant l'une des fréquences, choisie arbitrairement dans l'ensemble, par un seul bit qui est mis à 0 ou à 1 suivant que la fréquence en question est présente ou absente.

Lorsque le nombre N d'éléments de l'ensemble est peu supérieur à une puissance entière $2^k$, une autre solution consiste à mettre en oeuvre le procédé ci-dessus défini pour $2^k$ - 1 éléments (les premiers ou les derniers de la liste par exemple) et d'identifier les numéros d'ordre des autres sous forme cartographique.

Lorsque le nombre d'éléments de l'ensemble est de la forme $2^k$ - 1 et que le cardinal du sous-ensemble est optimal, le procédé suivant l'invention permet d'effectuer la transmission sur un nombre total de bit qui est proche du minimum théorique. Le gain n'est pas aussi élevé dans le cas particulier de la radio-téléphonie numérique cellulaire prévue par la norme, mais il est suffisant pour autoriser la transmission de la totalité des numéros d'ordre des 16 fréquences au maximum requises parmi 1 024 sur 128 bits, c'est-à-dire $2^4$ octets, même en réservant 2 bits d'en-tête. Les postes mobiles utilisés comportent des moyens permettant de faire correspondre une fréquence déterminée à chacun des numéros d'ordre de l'ensemble reçu et un décodeur permettant de fournir auxdits moyens le numéro d'ordre réel, en clair, à partir d'un message établi par le procédé ci-dessus défini.

Les moyens peuvent être constitués par un processeur, qui est de toute façon nécessaire dans le poste mobile pour remplir d'autres fonctions, lorsque les diverses fréquences possibles se déduisent les unes des autres par un algorithme mettant en jeu le numéro d'ordre. Ces moyens peuvent avoir d'autres constitutions et par exemple utiliser une table de correspondance stockée dans une mémoire morte programmable.

L'invention sera mieux comprise à la lecture de la description qui suit d'un mode particulier de réalisation et de variantes. La description se réfère aux dessins qui l'accompagnent, dans lesquels :
- les figures 1 et 2 sont des schémas en boucle montrant la sélection du premier et du second noeud ;
- la figure 3 montre un format possible de diffusion ;
- la figure 4 est un schéma de principe.

On décrira d'abord le procédé de codage ( et le procédé de décodage correspondant) permettant de réduire le nombre de bits nécessaires pour transmettre les numéros d'ordre de n fréquences appartenant à un ensemble de cardinal N, avant de donner, à titre d'exemple, le mode de codage et de décodage pour N = $2^k$-1 et un programme correspondant.

Le codage revient à un processus d'identification des éléments, dont le nombre maximum est n, d'un sous-ensemble par un processus de partition mettant en oeuvre une structure de sélection en arbre, le codage d'un élément dépendant des éléments antérieurement sélectionnés.

En sélectionnant un élément "parent", on constitue un groupe de gauche et un groupe de droite et dans chaque groupe on sélectionne un "descendant" suivant un critère de choix qui est le même que pour le parent : arbitrairement, on peut considérer que le second descendant est le descendant de gauche. Il est plus petit que le parent et peut être codé sur un nombre de bits inférieur d'une unité. Le descendant de droite est plus grand que le parent mais peut être réduit à une valeur plus faible par une opération de soustraction, qui permet de le coder sur le même nombre de bits que celui de gauche.

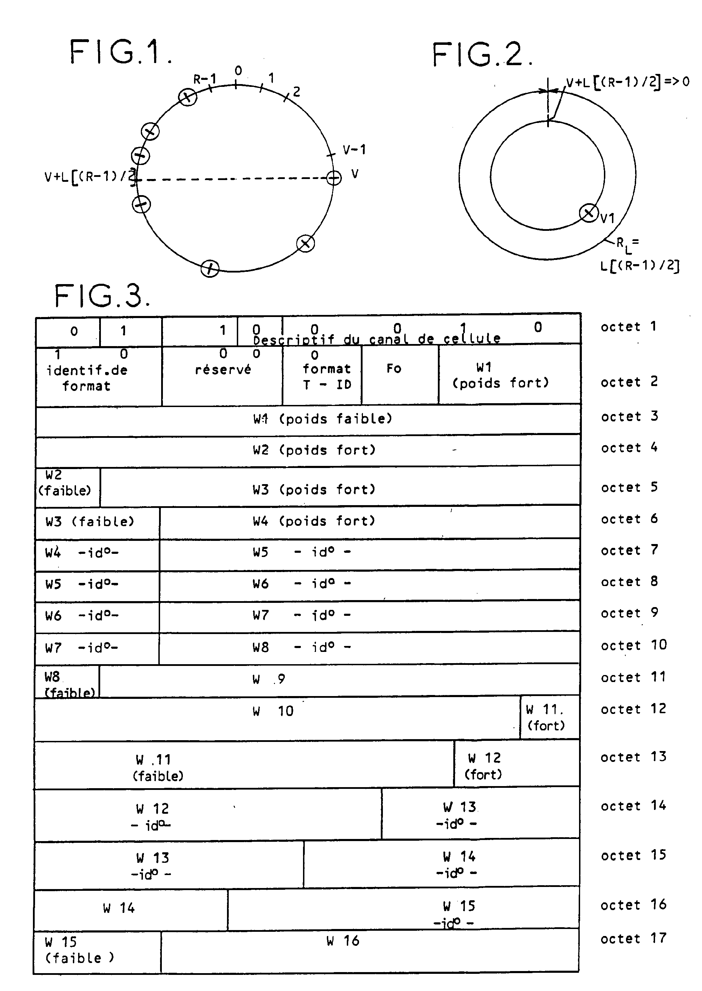

La première étape de processus de partition est schématisée en figure 1, sur laquelle sont montrés sept éléments constituant un sous-ensemble à identifier et à coder, parmi R éléments 0,1,... R-1. On prend comme noeud la valeur V qui sépare deux groupes :
- le groupe de droite, allant de V + 1 à V + L [(R-1)/2] (la notation L(·) désigne ici la partie entière);
- le groupe de gauche, allant de la valeur précédente, augmentée d'une unité, à V-1.

On voit sur la figure 1 que les deux groupes peuvent être définis sur une boucle, la valeur R-1 étant suivie de la valeur 0.

On peut montrer qu'il est toujours possible de trouver un élément dont la valeur V est telle qu'il y ait toujours exactement L(n/2) valeurs dans le groupe de gauche. C'est en général cette convention que l'on adoptera pour définir V. Une autre convention serait cependant également possible.

Une fois cette première partition effectuée, on détermine un premier et un second descendant, contenus chacun dans l'un des groupes. Par convention, on supposera par la suite que le second descendant est celui de gauche, le troisième descendant est celui de droite.

Comme le montre la figure 2, on commence par renuméroter les éléments du groupe de gauche à partir de V + L [(R-1)/2]. De façon similaire, on renumérote les éléments du groupe de droite à partir de V.

Le processus est alors repris et permet de déterminer à nouveau un descendant V1 par le même critère que précédemment.

A chaque partition, il est possible de coder les descendants sur un nombre de bits inférieur d'une unité à celui nécessaire pour le parent : si initialement k bits sont nécessaires, il suffira de k-1 bits pour les deux descendants immédiats, k-2 bits pour les quatres descendants suivants, etc.

La sélection des noeuds peut s'effectuer par un processus simple, mais lent, consistant à effectuer un test sur chaque élément à son tour ; on peut également envisager des algorithmes rapides, mais plus complexes.

On voit que les valeurs affectées à tous les noeuds ont un nombre de bits indépendant des valeurs à coder, c'est-à-dire des numéros d'ordre eux-mêmes, et ne dépendent que de conventions prédéterminées, mémorisées à l'émission et à la réception, et du cardinal de l'ensemble.

Comme on l'a indiqué plus haut, on obtient des résultats particulièrement favorables lorsque le cardinal de l'ensemble initial est égal à $2^k$-1, k étant quelconque mais entier. Dans ce cas, k bits sont tout juste nécessaires pour pouvoir coder le premier noeud tandis que k-1 puis k-2 bits, etc sont nécessaires pour les noeuds des générations suivantes. La structure est alors totalement binaire, et on évite la complexité qu'implique un codage et un décodage à radical mélangé.

Les opérations de décodage, dans le poste mobile, où les conventions choisies sont mémorisées, sont inverses de celles qui viennent d'être décrites. Le processeur identifie d'abord le premier noeud, dont le numéro d'ordre est donné directement en codage binaire. Il effectue ensuite les numérotations requises pour reconstituer les deux premiers descendants. Enfin le processeur, par utilisation de l'algorithme prédéterminé reliant les valeurs de fréquences à leurs numéros d'ordre, fournit à la partie d'émission et de réception du poste les valeurs de fréquences correspondant aux canaux à surveiller et/ou au canal sur lequel doit s'effectuer l'émission pour une communication avec l'infra-structure.

Les performances obtenues apparaissent immédiatement lorsque le cardinal de l'ensemble est égal à $2^k$-1.

Dans le cas, représentatif de la situation présentée par le radio-téléphone cellulaire, où N = $2^{10}$-1 = 1 023 et où n = 16, il faut :
- 10 bits pour le premier noeud,
- 9 bits pour chacun des deux noeuds suivants,
- 8 bits pour chacun des quatre noeuds suivants,

et ainsi de suite jusqu'à six bits pour le noeud unique de quatrième génération. Le total est donc de 122 bits.

Comme on l'a indiqué plus haut, 1 bit supplémentaire suffit pour permettre de porter le nombre total des fréquences entre lesquelles le choix doit être fait à 1 024.

Pour une valeur quelconque N du cardinal de l'ensemble, le nombre de bits nécessaires est :

$$N \, \frac{\log n}{\log 2} \; - \; \sum_{i \, = \, 1}^{N} \left[ \frac{\log i}{\log 2} \right]$$

où [x] désigne la partie entière de x.

L'économie sur le nombre de bits, comparée à un mode de codage consistant à donner toutes les valeurs constituant le sous-ensemble sous forme d'un nombre ayant le nombre maximum de bits nécessaires, dépend du nombre des éléments. A titre d'exemple on trouvera ci-après quelques valeurs :

| n | 1 | 2 | 3 ... | 15... | 23... | 30 |
|---|---|---|---|---|---|---|
| économie (bits) | 0 | 1 | 2 | 34 | 66 | 94 |

et le tableau ci-après donne le nombre de bits requis dans un certain nombre de cas représentatifs :

| Cardinal de l'ensemble | Nombre d'éléments du sous-ensemble | Nombre de bits requis |
|---|---|---|
| 1 023 = $2^{10}$-1 | 14 | 109 |
|  | 15 | 116 |
|  | 16 | 122 |
| 511 = $2^{9}$-1 | 20 | 106 |
|  | 22 | 114 |
|  | 25 | 126 |

A titre d'exemple on décrira maintenant une séquence d'opérations de partition destinées à communiquer à un poste mobile un sous-ensemble particulier d'éléments, constitués de seize numéros d'ordre appartenant à un ensemble de $2^{10}$ numéros d'ordre de fréquences ayant des valeurs $f_0$, ..., $f_{1023}$. Ce sous-ensemble sera supposé être constitué par les fréquences ayant pour numéros d'ordre 12,70,121,190,250,320,401,475, 520,574,634,700,764,830,905, 980.

Pour réduire le cardinal de l'ensemble de 1 024 à 1 023, on identifie une fréquence, choisie arbitrairement, par un seul bit. Sa présence ou son absence sont indiquées simplement par envoi d'un bit. Cette fréquence doit être mémorisée dans le poste mobile. Il peut s'agir de $f_0$ ou $f_{1\ 023}$ par exemple. Cela laisse à transmettre au maximum seize éléments constitués par seize numéros entre 1 et 1 023.

Un premier noeud est alors constitué par l'élément V = 520 qui a pour valeur "opposée" [520 + ($2^9$-1)] modulo ($2^{10}$-1) c'est-à-dire 8 : il y a en effet huit éléments compris entre 9 et 519 (au groupe de gauche 12,70,121,190-250,320,401,475) et sept éléments entre 521 et 8, comme l'indique le tableau suivant.

## TABLEAU I

520

(opposé = 8)

| 12 | (3) | 574 |
|---|---|---|
| 70 | (61) | 634 |
| 121 | (112) | 700 |
| 190 | (181) | 764 |
| 250 | (241) | 830 |
| 320 | (311) | 905 |
| 401 | (392) | 980 |
| 475 | (466) | |

Arbitrairement, dans le cas (qui est celui de l'exemple ci-dessus) où le nombre d'éléments à partager est pair, le noeud est choisi de façon qu'il y ait un élément de plus dans le groupe de gauche : la convention contraire pourrait être utilisée, l'essentiel étant qu'elle soit mémorisée dans le poste.

Le premier noeud est codé sur 10 bits, même lorsqu'un nombre de bits plus faible suffirait.

Le second noeud est constitué par le descendant du premier noeud, arbitrairement dans le groupe de gauche, renuméroté à partir de neuf, c'est-à-dire de l'opposé de 520 . Cette renumérotation est indiquée entre parenthèses sur le tableau ci-dessus. On voit que la valeur 112, (correspondant à l'élément numéroté à l'origine 121), partage le groupe en deux sous-groupes de quatre et trois éléments respectivement.

Le troisième noeud est constitué par le descendant du premier dans le groupe de droite. La renumérotation s'effectue cette fois à partir de 521, encore de 1 à $2^9$-1 = 511 ce qui donne sept éléments numérotés 53,113,179, 243,309,384 et 459.

La valeur 53 sépare ce groupe en deux sous-groupes de trois éléments, compris entre 54 et la valeur 309 opposée à 53.

Dans la nouvelle numérotation les second et troisième noeuds peuvent être codés sur neuf bits, puisque leur valeur est inférieure à 512.

La démarche est poursuivie pour obtenir les noeuds suivants. Arbitrairement, on considère ici que chaque noeud pair 2m est le descendant de gauche du noeud m tandis que le noeud impair 2m+1 est le descendant de droite du noeud m.

Les noeuds successifs sont alors identifiés par les valeurs du tableau II :

## TABLEAU II

| Noeud | Valeur | Nombre de bits |
|-------|--------|----------------|
| 1 | 520 | 10 |
| 2 | 112 | 9 |
| 3 | 53 | |
| 4 | 146 | 8 |
| 5 | 68 | |
| 6 | 0 | |
| 7 | 59 | |
| 8 | 5 | 7 |
| 9 | 57 | |
| 10 | 2 | |
| 11 | 59 | |
| 12 | 22 | |
| 13 | 74 | |
| 14 | 2 | |
| 15 | 65 | |
| 16 | 10 | 6 |

Le codage à radical mixte est, dans ce cas particulier où N = $2^k$-1, très simple car il est tel qu'il y a une correspondance exacte entre des valeurs et des mots ayant un nombre décroissant de bits.

Les valeurs ci-dessus, plus une, sont alors codées dans l'ordre approprié, puis transmises sur 10 bits, sur 9 bits, sur 8 bits, sur 7 bits et enfin (pour un seul élément dans le cas d'un sous-ensemble de 16 éléments) sur 6 bits.

Le décodage est également très simple. Par exemple pour le second noeud, la valeur d'origine est :
$$(520 + 511 + 113) \bmod 1\,023 = 121$$
tandis que pour le noeud 11, la valeur d'origine est :
$$\{520 + 511 + [113 + (69 + 60)\ \text{smod}\ 255]\ \text{smod}\ 511\}\ \bmod 1\,023$$
c'est-à-dire 250.

6

Dans la formule ci-dessus on désigne par (n smod p) la valeur entière r pour laquelle il existe un nombre d tel que $1 \leq r \leq p$ et n = dp + r.

Cette formulation est utilisée pour différencier du modulo, qui est tel que $0 \leq r \leq p\text{-}1$.

Le codage et le décodage peuvent être effectués aisément par voie logicielle. On décrira ci-après, à titre de simple exemple, un programme de décodage correspondant à un cas et à un langage particulier.

On désignera par $w_i$ le ième mot apparaissant dans le champ. Lorsque $w_i$ est égal à zéro, la description du sous-ensemble est terminée et tous les bits suivants du champ sont mis à zéro. Dans le cas d'un format de message de diffusion du genre montré en figure 3, les numéros d'ordre du sous-ensemble sont calculés comme suit.

Le bit $f_0$ indique si la fréquence $F_0$ est présente ou non : dans l'affirmative, elle est immédiatement identifiée.

Les numéros d'ordre des 16 fréquences $F_1$ à $F_{16}$ ou $F_0$ à $F_{15}$ (le nombre pouvant être inférieur à 16) sont donnés par :

```
F₁  =   W₁  smod 1023
F₂  = (W₁  -  512  +  W₂) smod 1023
F₃  = (W₁           +  W₃) smod 1023
F₄  = (W₁  -  512  +  (W₂  -  256  +  W₄) smod 511) smod 1023
F₅  = (W₁           +  (W₃  -  256  +  W₅) smod 511) smod 1023
F₆  = (W₁  -  512  +  (W₂           +  W₆) smod 511) smod 1023
F₇  = (W₁           +  (W₃           +  W₇) smod 511) smod 1023
F₈  = (W₁  -  512  +  (W₂  -  256  +  (W₄  -  128  +  W₈ ) smod 255)
        smod 511) smod 1023
F₉  = (W₁           +  (W₃  -  256  +  (W₅  -  128  +  W₉ ) smod 255)
        smod 511) smod 1023
F₁₀ = (W₁  -  512  +  (W₂           +  (W₆  -  128  +  W₁₀) smod 255)
        smod 511) smod 1023
F₁₁ = (W₁           +  (W₃           +  (W₇  -  128  +  W₁₁) smod 255)
        smod 511) smod 1023
F₁₂ = (W₁  -  512  +  (W₂  -  256  +  (W₄           +  W₁₂) smod 255)
        smod 511) smod 1023
F₁₃ = (W₁           +  (W₃  -  256  +  (W₅           +  W₁₃) smod 255)
        smod 511) smod 1023
F₁₄ = (W₁  -  512  +  (W₂           +  (W₆           +  W₁₄) smod 255)
        smod 511) smod 1023
F₁₅ = (W₁           +  (W₃           +  (W₇           +  W₁₅) smod 255)
        smod 511) smod 1023
F₁₆ = (W₁  -  512  +  (W₂  -  256  +  (W₄  -  128  +  (W₈  -  64  +  W₁₆)
        smod 127) smod 255) smod 511) smod 1023
```

Chaque W(i), dans les octets 2 à 17, constitue la valeur codée d'un nombre entier non négatif, sous forme binaire. Si W(i) est nul pour une valeur 1, dans ce cas les mots W(1+1) à W(16) sont également nuls. Les conventions adoptées sont les suivantes :
- + indique l'addition de nombres entiers naturels,
- * indique la multiplication de nombres entiers naturels,
- n mod m indique le reste de la division euclidienne de n par m, c'est-à-dire $0 \leq (n \bmod m) \leq m\text{-}1$, ce qui implique qu'il existe une valeur p telle que

$$p = k{*}m + (n \bmod m).$$

Le programme peut être le suivant, en langage ADA. Les déclarations ont été sautées car elles sont évidentes :

```
INDEX := K;
J := GREATEST_POWER_OF_2_LESSER_OR_EQUAL_TO(INDEX);
N := W(INDEX);
while INDEX>1 loop
    PARENT_INDEX := J/2 + (INDEX-J) mod (J/2);
    if 2*INDEX < 3*J then          -- descendant gauche
        N := (N + W(PARENT_INDEX) - 1024/J - 1) mod (2048/J - 1)
            + 1;
    else                                  -- descendant droit
        N := (N + W(PARENT_INDEX) - 1) mod (2048/J - 1) + 1;
    end if;
    INDEX := PARENT_INDEX;
    J := J/2;
end loop;
F(K) := N;
```

Le codage s'effectue par un processus dual de celui du décodage et en conséquence le programme de codage peut se déduire directement du programme de décodage qui vient d'être donné.

L'invention est susceptible de nombreuses variantes de réalisation dont seules certaines seront brièvement évoquées maintenant.

Une première variante de réalisation consiste à simplifier le codage en n'utilisant pas complètement l'arithmétique en base radical mélangé mais plutôt en utilisant le codage d'une valeur donnée avec un nombre entier de bits. On peut par exemple dans ce cas utiliser 9 bits pour coder une valeur comprise entre 0 et 350. Cela signifie le codage et le décodage car on remplace les divisions et les multiplications par de simples décalages. Le coût au point de vue nombre de bits est d'environ 1/2 bit par valeur codée ; pour l'exemple donné plus haut, le nombre de bits requis est alors accru d'une quantité qui est nulle lorsque N est égal à $2^k-1$, quel que soit k entier.

Un autre processus encore permettant de préserver à la fois le codage binaire pur et les performances lorsque le cardinal de l'ensemble est peu supérieur à $2^k-1$ consiste à utiliser une cartographie pour les valeurs au-delà de $2^k-1$.

Une autre variante de réalisation permet d'adapter le procédé de codage et de décodage décrit plus haut au cas où les sous-ensembles possibles ne représentent qu'une fraction déterminée de tous les sous-ensembles de l'ensemble de N éléments.

Cette variante implique de donner, au début du format, l'indication du domaine ou de la fraction de l'ensemble dans lequel se trouvent tous les éléments des sous-ensembles à coder. Plusieurs façons de faire sont possibles.

- Une première solution consiste à donner la valeur basse et la valeur haute du domaine dans lequel se trouvent les éléments. Cela exige 2 log N-1 bits. Les bits disponibles restants servent à coder les valeurs. La relation entre la valeur k telle que tous les sous-ensembles ayant jusqu'à k valeurs puissent être codés et le domaine (valeur maximum moins valeur minimum) est la suivante, dans le cas de 124 bits au maximum :

| Domaine | Nombre max. d'éléments |
|---|---|
| 1023 | 15 |
| 511 | 17 |
| 255 | 21 |

Evidemment, si le domaine comporte 106 éléments ou plus, il est plus avantageux d'utiliser un codage cartographique.

- Une seconde solution consiste à coder d'abord la valeur basse ( sur dix bits dans le cas de l'exemple ci-dessus ) puis le domaine ( valeur haute-valeur basse ), par exemple sur trois bits. La relation devient alors la suivante :

| Domaine | Nombre max. d'éléments |
|---------|------------------------|
| 1023 | 15 |
| 511 | 18 |
| 255 | 22 |
| 127 | 29 |

Pour un domaine inférieur à 112 éléments, on a intérêt à coder de façon cartographique.

On voit qu'il n'y a ni gain, ni perte pour les domaines étendus, mais qu'il y a un avantage dans le cas des domaines de moins de 150 éléments.

Enfin, une autre variante encore consiste à ne pas donner la première valeur exactement, mais d'indiquer seulement un repère parmi plusieurs, indiquant que le domaine ne descend pas au-dessous de ce repère. Le repère peut par exemple être choisi parmi 21 valeurs différentes dans le cas envisagé plus haut.

A titre d'exemple supplémentaire on donnera maintenant les caractéristiques d'un procédé utilisable pour la sélection des fréquences dans la bande de 374 prévue pour le GSM (global system for mobiles). Les valeurs suivantes sont normalisées :

| Nombre total de fréquences | Nombre de fréquences dans dans l'ensemble transmis | |
|---|---|---|
| 1024 | 18 ◄——————— | 18 |
| 512 | 19 ◄——————— | 19 |
| 256 | 23 ◄——————— | : |
| 128 | 30 ◄——————— | 30 |

Dans le premier cas on réduit le nombre de fréquences de 1024 à 1023 par codage séparé d'une fréquence, ce qui ramène à N = 1023 et n $\leq$ 15.

Dans les trois autres cas, l'ensemble de base est défini en donnant, en clair, une fréquence d'origine parmi les 1024. Le numéro d'ordre de cette fréquence faisant partie de l'ensemble, la partie codée correspond aux paramètres :

| N | n |
|---|---|
| 511 | 18 |
| 255 | 22 |
| 127 | 29 |

Les quatre cas tombent dans le cadre général d'un ensemble $2^k-1$, avec k respectivement égal à 10,9,5 et 7.

Pour des applications radio-téléphoniques éventuelles autres que le GSM, il y a peu ou pas d'intérêt à aller plus loin que le double du cas maximal (N=2047, n=32), cela donne un champ codé de l'ordre de 32 octets.

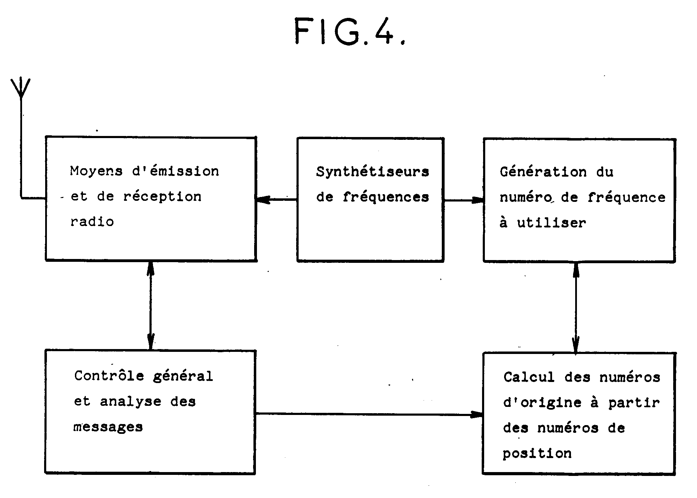

Il n'est pas nécessaire de décrire la constitution des composants car ils peuvent être de nature classique et par exemple capables de fonctionner, dans le récepteur, suivant le schéma de la figure 4.

**Revendications**

1. Procédé de radiotéléphonie numérique de communication entre une infrastructure et des postes mobiles suivant lequel : on diffuse, à partir de l'infrastructure fixe vers les postes mobiles émetteurs-récepteurs, les numéros d'ordre de fréquences de travail, constituant un sous-ensemble quelconque, de cardinal au plus égal à une valeur déterminée n, d'un ensemble de fréquences prédéterminées de cardinal N ; on identifie, dans chaque poste à l'écoute, les fréquences du sous-ensemble à partir des numéros d'ordre et on provoque le fonctionnement du poste sur les fréquences identifiées,

caractérisé en ce que, pour diffuser les numéros d'ordre de fréquences appartenant à un ensemble de cardinal $2^k$ - 1, k étant un nombre entier, on détermine le numéro V d'une fréquence de partition appartenant au sous-ensemble, qui délimite, dans l'intervalle [0, $2^k$ - 2], deux groupes contenant les $2^{k-1}$ - 1 numéros respectivement précédant et suivant V dans une disposition circulaire dudit intervalle, V étant choisi tel que L(n/2) numéros de fréquences du sous-ensemble appartiennent à l'un des deux groupes, L(.) désignant la partie entière ; on définit le numéro de la fréquence de partition retenue sur k bits ; on renumérote les numéros d'ordre des deux groupes délimités ; on répète la détermination du numéro de la fréquence sur chaque groupe et on définit les deux fréquences de partition sur k-1 bits ; on répète les opérations de renumérotation, de détermination et de définition jusqu'à épuisement des numéros d'ordre à transmettre ; et on transmet les numéros d'ordre des fréquences de partition suivant une séquence déterminée, connue du poste de l'émetteur-récepteur ; et on détermine les fréquences de travail à partir des numéros d'ordre dans le poste.

2. Procédé selon la revendication 1, caractérisé en ce qu'on l'utilise pour diffuser les numéros d'ordre de fréquences contenues dans un ensemble de cardinal $2^k$ - 1, en transmettant par un procédé différent les numéros d'ordre supplémentaires éventuels.

3. Procédé selon la revendication 2, caractérisé en ce qu'on réduit le nombre N des éléments de $2^k$ à $2^k$ - 1 en identifiant l'une des fréquences, choisie arbitrairement dans l'ensemble, par un seul bit qui est mis à 0 ou à 1 suivant que la fréquence en question est présente ou absente dans ledit sous-ensemble.

4. Procédé selon la revendication 2, caractérisé en ce que, le nombre N d'éléments étant peu supérieur à $2^k$, on l'utilise pour coder $2^k$ - 1 éléments (les premiers ou les derniers de la liste par exemple) et on identifie les numéros d'ordre des autres éléments sous forme cartographique.

5. Poste de radio-téléphonie mobile pour installation de radio-téléphonie numérique cellulaire à modulation à saut de fréquence, comportant des moyens d'émission-réception sur plusieurs fréquences définies par des numéros d'ordre et constituant un sous-ensemble de fréquences, de cardinal au plus égal à n, appartenant à un ensemble de fréquences dont les numéros d'ordre constituent un ensemble de cardinal N, des moyens d'écoute sur un canal de diffusion, des moyens de génération de fréquence permettant de faire correspondre une fréquence déterminée à chacun des numéros d'ordre de l'ensemble, caractérisé en ce qu'il comprend en outre un décodeur pour fournir auxdits moyens le numéro d'ordre réel, en clair, à partir d'un message contenant la liste des numéros codés par le procédé suivant la revendication 1.

6. Poste selon la revendication 5, caractérisé en ce que les moyens générateurs comprennent un processeur générant les diverses fréquences possibles par un algorithme mettant en jeu le numéro d'ordre.

## Patentansprüche

1. Verfahren für digitale Funktelefonie zur Kommunikation zwischen einer Infrastruktur und mobilen Stationen, bei dem man von der festen Infrastruktur aus an die mobilen Sender-Empfängerstationen die Ordnungsnummern von Arbeitsfrequenzen sendet, die irgendeine Untermenge mit einer Grundzahl höchsten gleich einem vorbestimmten Wert n einer Menge von durch die Grundzahl N vorbestimmten Frequenzen bilden, bei dem man in jeder Abhörstation die Frequenzen der Untermenge von den Ordnungsnummern identifiziert und bei dem man den Betrieb der Station auf den identifizierten Frequenzen veranlaßt, **dadurch gekennzeichnet, daß** man, um die Ordnungsnummern der Frequenzen zu senden, die zu einer Grundmenge $2^{k-1}$ gehören, wobei k eine ganze Zahl ist, die Nummer V einer Einteilungsfrequenz bestimmt, die zur Untermenge gehört und die im Intervall [0, $2^k$ - 2] zwei Gruppen abgrenzt, die die $2^{k-1}$ -1 Nummern enthalten, die V in einer kreisförmigen Anordnung des besagten Intervalls vorausgehen beziehungsweise folgen, wobei V so ausgewählt wird, daß L (n/2) Nummern von Frequenzen der Untermenge einer der beiden Gruppen angehören, wobei L(.) die gesamte Teilmenge bezeichnet, daß man die Nummer der erhaltenen Einteilungsfrequenz über k Bits kennzeichnet, daß man die Ordnungsnummern der zwei abgegrenzten Gruppen umnumeriert, daß man die Bestimmung der Nummer der Frequenz in jeder Gruppe wiederholt und daß man die zwei Einteilungsfrequenzen über k-1 Bits kennzeichnet, daß man die Umnumerierungs-, Bestimmungs- und Kennzeichnungsarbeitsgänge bis zur Ausschöpfung der zu sendenden Ordnungsnummern wiederholt, und daß man die Ordnungsnummern der Einteilungsfrequenzen nach einer bestimmten der Sender-Empfängerstation bekannten Abfolge sendet, und daß man die Arbeitsfrequenzen von den Ordnungsnummern aus in der Station bestimmt.

2. Verfahren nach Anspruch 1, **dadurch gekennzeichnet, daß** man zum Senden die Ordnungsnummern der Frequenzen verwendet, die in einer Grundmenge $2^k$ - 1 enthalten sind, indem man in einem unterschiedlichen Verfahren die gegebenenfalls zusätzlichen Ordnungsnummern sendet.

3. Verfahren nach Anspruch 2, **dadurch gekennzeichnet, daß** man die Anzahl N der Glieder von $2^k$ auf $2^k$ -1 verringert, indem man eine der Frequenzen, die willkürlich aus der Menge ausgewählt wurde, durch ein einziges Bit kennzeichnet, das auf 0 oder auf 1 gesetzt wird, je nach dem die fragliche Frequenz in der besagten Untermenge vorliegt oder fehlt.

4. Verfahren nach Anspruch 2, **dadurch gekennzeichnet, daß** man, wenn die Anzahl N von Gliedern wenig größer als $2^k$ ist, zum Kodieren $2^k$ -1 Glieder verwendet (beispielsweise die ersten oder die letzten der Liste), und daß man die Ordnungsnummern der anderen Glieder in kartographischer Form kennzeichnet.

5. Mobile Funktelefoniestation zur Einrichtung der digitalen Zellulartelefonie mit Frequenzsprungsmodulation umfassend eine Sende-Empfangseinrichtung auf mehreren durch Ordnungsnummern bestimmten Frequenzen, die eine Untermenge von Frequenzen mit einer Grundzahl höchsten gleich n bilden, die zu einer Menge von Frequenzen gehören, deren Ordnungsnummern eine Menge der Grundzahl N bilden, eine Abhöreinrichtung auf einem Sendekanal und eine Frequenzgeneratoreinrichtung, die es erlauben, eine bestimmte Frequenz jeder der Ordnungsnummern der Menge entsprechen zu lassen, **dadurch gekennzeichnet, daß** sie außerdem einen Dekodierer umfaßt, der den besagten Einrichtungen klar die reelle Ordnungsnummer von einer Meldung liefert, die die Liste der Nummern enthält, die durch das Verfahren nach Anspruch 1 kodiert wurden.

6. Station nach Anspruch 5, **dadurch gekennzeichnet, daß** die Generatoreinrichtung einen Prozessor umfassen, der die verschiedenen möglichen Frequenzen durch einen Algorithmus erzeugt, der die Ordnungsnummer ins Spiel bringt.

## Claims

1. Process for digital radio-telephone communication between an infrastructure and mobile stations, including the steps of: broadcasting, from the stationary infrastructure toward the mobile transmitter-receiver stations, the serial numbers of working frequencies which constitute any sub-set, having a cardinal number at most equal to a predetermined value n, of a set of predetermined frequencies having a cardinal number N; identifying, in each receiving station, the working frequencies of the sub-set by deriving them from the serial numbers; and causing the station to operate on the identified frequencies,
characterized in that, for broadcasting, the serial numbers of frequencies belonging to a set of cardinal numbers $2^k$-1, k being an integer, the serial number V of a partition frequency belonging to said sub-set which delimits, in the interval [0, $2^k$-2], two groups including the $2^k$-1 serial numbers respectively preceding and following V in a circular arrangement of said interval is determined, V being chosen such that L(n/2) serial numbers of frequencies of said sub-set belong to one of the two groups, L(.) designating the integer part; the serial number of the retained partition frequency is identified on k bits; the serial numbers in the two delimited groups are renumbered; determination of the serial number of a partition frequency is repeated on each group and the two partition frequencies are defined on k-1 bits; the operations of renumbering, determination and definition are repeated until the serial numbers to be transmitted are exhausted; all serial numbers of the partition frequencies are transmitted according to a predetermined sequence known at the transmitter-receiver station; and the working frequencies are determined from the serial numbers, in the station.

2. Process according to claim 1, characterized in that it is used for broadcasting the serial numbers of frequencies included in a set of cardinal number $2^k$-1 while transmitting the possible additional serial numbers in a different way.

3. Process according to claim 2, characterized in that the number N of the elements is decreased from $2^k$ to $2^k$-1 by identifying one of the frequencies, arbitrarily selected within the set, with a single bit which is set to zero or to one depending on whether the relevent frequency is present or not in said sub-set.

4. Process according to claim 2, characterized in that, the number N of elements being only slightly higher than $2^k$, it is used for encoding $2^k$-1 elements (for instance, the first elements or the last elements of the list) and the serial numbers of the other elements are identified by mapping.

5. Mobile radio-telephone station for a cellular digital radio-telephone system using frequency hopping modulation comprising transmitter-receiver means over a plurality of frequencies defined by serial numbers and constituting a sub-set of frequencies having a cardinal number at most equal to n, included in a set of frequencies whose serial numbers constitute a set having a cardinal number N, means for monitoring a broadcasting channel, frequency generating means for assigning a predetermined frequency to each of the serial numbers of the set, characterized in that if further comprises a decoder for providing the actual serial number, in clear, to said means from a message containing the list of numbers encoded by the process according to claim 1.

6. Station according to claim 5, characterized in that the generating means comprise a processor which generates the different possible frequencies through an algorithm involving the serial number.

# FIG.1.

# FIG.2.

# FIG.3.

| | | | | | | | | |
|---|---|---|---|---|---|---|---|---|
| 0 | 1 | | 1 | 0 | 0 | 0 | 1 | 0 | octet 1 |

Descriptif du canal de cellule

| 1 0 identif.de format | 0 0 réservé | 0 format T – ID | Fo | W1 (poids fort) | octet 2 |

| W1 (poids faible) | octet 3 |

| W2 (poids fort) | octet 4 |

| W2 (faible) | W3 (poids fort) | octet 5 |

| W3 (faible) | W4 (poids fort) | octet 6 |

| W4 -id°- | W5 - id° - | octet 7 |

| W5 -id°- | W6 - id° - | octet 8 |

| W6 -id°- | W7 - id° - | octet 9 |

| W7 -id°- | W8 - id° - | octet 10 |

| W8 (faible) | W 9 | octet 11 |

| W 10 | W 11. (fort) | octet 12 |

| W .11 (faible) | W 12 (fort) | octet 13 |

| W 12 - id°- | W 13 -id° - | octet 14 |

| W 13 -id° - | W 14 -id° - | octet 15 |

| W 14 | W 15 -id° - | octet 16 |

| W 15 (faible ) | W 16 | octet 17 |

# FIG.4.

| Moyens d'émission - et de réception radio | Synthétiseurs de fréquences | Génération du numéro de fréquence à utiliser |

| Contrôle général et analyse des messages | | Calcul des numéros d'origine à partir des numéros de position |